# FASCICULE DE BREVET EUROPEEN

(11) **EP 3 006 119 B1**
(45) Date de publication et mention de la délivrance du brevet: **01.09.2021**
(21) Numéro de dépôt: 14187778.7
(22) Date de dépôt: 06.10.2014
(51) Int. Cl.: B06B 1/02, B06B 1/06, H04R 17/10

(54) **Dispositif électronique de génération d'un avertissement sonore ou d'une musique**
Elektronische Vorrichtung zur Erzeugung eines akustischen Alarms oder einer Musik
Electronic device for generating a warning sound or music

(43) Date de publication de la demande: 13.04.2016
(73) Titulaire: The Swatch Group Research and Development Ltd., 2074 Marin (CH)
(72) Inventeur: Bracco, Massimiliano, 2525 Le Landeron (CH)
(74) Mandataire: Giraud, Eric

(56) Documents cités:
- WO-A2-2005/114833
- GB-A- 2 452 790
- US-A- 4 972 438
- US-A1- 2005 162 223
- US-A1- 2012 119 797

## Description

L'invention concerne un dispositif électronique pour générer un avertissement sonore ou une musique. Le dispositif peut équiper un instrument électronique portable, tel qu'une montre. Le dispositif comprend notamment au moins une bobine liée à un vibreur acoustique de type capacitif.

Dans des systèmes électroniques conventionnels munis d'au moins un vibreur acoustique notamment muni d'un élément piézoélectrique, il est prévu une bobine liée au vibreur acoustique, qui tous deux sont connectés à un circuit de commande. Le circuit de commande peut comprendre un transistor disposé en série avec la bobine et le vibreur entre deux bornes d'une source de tension d'alimentation. Lors de la mise en fonction du système électronique pour la génération d'un son, tel qu'une alarme, des impulsions sont imposées à la grille ou base du transistor pour exciter l'ensemble composé par la bobine et le vibreur acoustique.

Un circuit connu est par exemple décrit dans US 2005/162223 A1. Ce document décrit un amplificateur de classe D pour une modulation de largeur d'impulsions d'un signal analogique d'entrée afin de sortir un signal modulée. Le dispositif électronique comprend une bobine ou inductance et un haut-parleur comme charge et un condensateur relié en série avec la bobine, pour la génération d'un avertissement sonore ou d'une musique lors de la mise en fonction du dispositif électronique, et une boucle de rétroaction negative, comprenant un circuit dérivateur relié à un noeud de connexion entre la bobine et le condensateur du vibreur, pour dériver le signal provenant du condensateur, et un comparateur pour comparer un signal de dérivée du circuit dérivateur avec une tension de référence, le comparateur fournissant un signal de sortie à la bobine pour amplifier le signal sur le condensateur.

Généralement, il est recherché d'adapter la fréquence du circuit de commande en fonction de la fréquence de résonance de l'ensemble composé par la bobine et le vibreur acoustique. Pour ce faire, une première phase doit être prévue pour la mesure de la fréquence de résonance. Ensuite dans une boucle de rétroaction, la réponse de l'ensemble mécanique de génération de son peut être échantillonnée, afin d'adapter la fréquence des impulsions de commande. Cette fréquence doit être adaptée proche de la fréquence de résonance de l'ensemble mécanique pour générer un son ayant un niveau sonore suffisant tout en limitant l'énergie électrique nécessaire. Cependant, on constate qu'il est difficile de travailler en permanence à cette fréquence adaptée pour le circuit de commande, car l'ensemble mécanique est souvent sujet à un changement naturel de ses paramètres physiques dans le temps. Le remplacement du système résonant dans une opération de service après-vente peut aussi dégrader l'efficacité du dispositif initial. Cela constitue un inconvénient d'un tel système électronique conventionnel.

L'invention a donc pour but de fournir un dispositif électronique pour générer un avertissement sonore ou une musique palliant les inconvénients susmentionnés de l'état de la technique, afin de générer une alarme ou musique à volume élevé à faible tension d'alimentation quelle que soit l'évolution dans le temps du système résonant.

A cet effet, l'invention concerne un dispositif électronique de génération d'un avertissement sonore ou d'une musique, qui comprend les caractéristiques mentionnées dans la revendication indépendante 1.

Des formes d'exécution particulières du dispositif électronique de génération d'un avertissement sonore ou d'une musique sont définies dans les revendications dépendantes 2 à 10.

Un avantage du dispositif électronique de génération d'un avertissement sonore réside dans le fait qu'une boucle de rétroaction positive est prévue dans laquelle il est mesuré la dérivée de la tension sur l'avertisseur ou vibreur acoustique du type capacitif. Un effet résonant est obtenu sans devoir calculer la fréquence de résonance de l'ensemble composé de la bobine et du vibreur acoustique, et ceci indépendamment des variations des paramètres physiques ou du changement du vibreur acoustique.

Les buts, avantages et caractéristiques du dispositif électronique de génération d'un avertissement sonore ou d'une musique apparaîtront mieux dans la description suivante sur la base d'au moins une forme d'exécution non limitative et illustrée par les dessins sur lesquels :
la figure 1 représente de manière simplifiée les différents composants du dispositif de génération d'un avertissement sonore ou d'une musique selon l'invention,
la figure 2 représente différents signaux dans le dispositif de génération d'un avertissement sonore ou d'une musique selon l'invention, et
la figure 3 représente l'évolution d'un signal en sortie du vibreur acoustique, modélisé en première approximation par un condensateur, lors du fonctionnement du dispositif selon l'invention.

Dans la description suivante, tous les composants électroniques du dispositif électronique, qui sont bien connus d'un homme du métier dans ce domaine technique, ne sont décrits que de manière simplifiée.

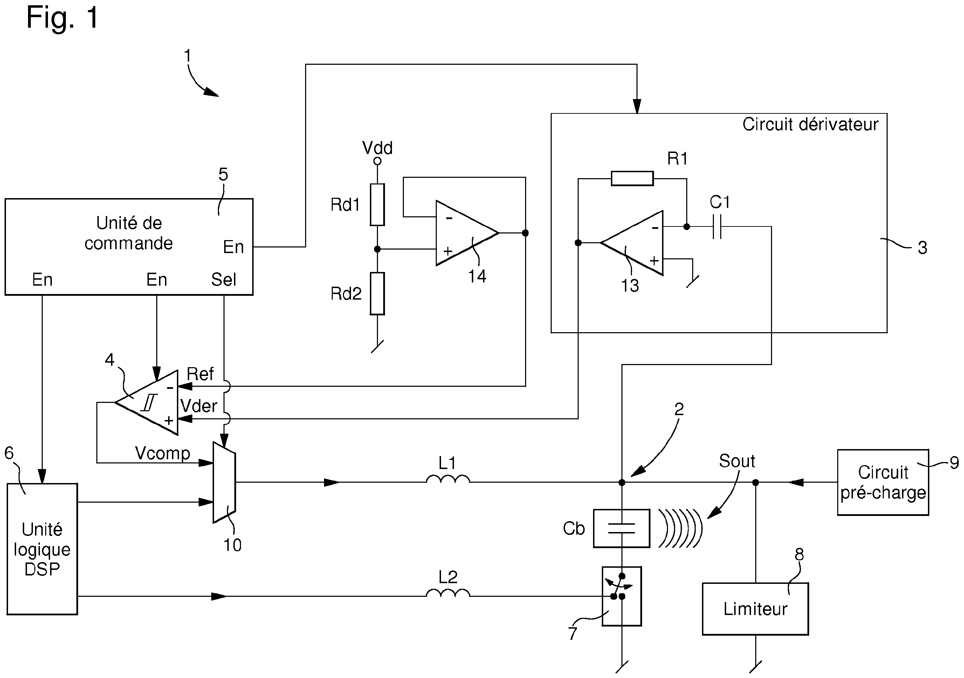

A la figure 1, une forme d'exécution du dispositif électronique ou circuit électronique 1 est représentée. Le dispositif électronique 1 peut être alimenté par une source de tension d'alimentation conventionnelle, telle qu'une batterie. Le dispositif électronique 1 comprend un ensemble 2 composé d'une première bobine ou inductance L1 reliée à un vibreur acoustique Cb du type capacitif pour la génération d'un son ou d'une musique Sout. La première bobine L1 est reliée à une première électrode du vibreur Cb, alors que la seconde électrode du vibreur Cb peut être reliée par l'intermédiaire d'un interrupteur 7 à une tension nulle ou à une borne de masse.

Il est à noter qu'un vibreur acoustique Cb peut être composé d'une membrane acoustique sur laquelle est disposé un élément piézoélectrique. Cet élément piézoélectrique peut être activé électriquement pour faire vibrer la membrane, qui génère ainsi un son ou une musique. L'élément piézoélectrique est généralement composé entre une première électrode et une seconde électrode dans une première branche d'une résistance, d'une inductance et d'un premier condensateur en série, et dans une seconde branche parallèle d'un second condensateur. Le second condensateur est de grandeur bien supérieure aux autres composants de la première branche et en première approximation, il est possible de considérer ledit élément piézoélectrique comme un condensateur Cb. Dans ces conditions, il est défini dans la description un vibreur acoustique du type capacitif, car la génération d'un son ou d'une musique par la membrane est obtenue par l'activation du condensateur Cb.

Dans une boucle de rétroaction, le dispositif électronique 1 comprend encore un circuit dérivateur 3, qui est relié au nœud de connexion de la première bobine L1 et du vibreur acoustique Cb. Le circuit dérivateur 3 est prévu pour effectuer une dérivée du signal sur la première électrode du vibreur Cb. Le signal de dérivée Vder à la sortie du circuit dérivateur 3 est fourni à une première entrée d'un comparateur 4, dont une seconde entrée reçoit une tension de référence Ref pour la comparaison avec le signal de dérivée Vder du circuit dérivateur 3. De préférence, la première entrée du comparateur 4 est une entrée positive, alors que la seconde entrée du comparateur 4 est une entrée négative. De plus, la tension de référence Ref peut être fixée à la moitié de la tension d'alimentation Vdd du dispositif électronique, c'est-à-dire à Vdd/2. Le signal de sortie Vcomp du comparateur 4 est fourni à une extrémité libre de la première inductance L1 pour activer la génération d'un son ou d'une musique Sout par le vibreur acoustique Cb.

Il est à noter que la tension de référence Ref peut être obtenue par un diviseur résistif composé d'une première résistance Rd1 et d'une seconde résistance Rd2, qui sont reliées en série à une source de tension d'alimentation Vdd, qui alimente les différents composants du dispositif électronique 1. De préférence un amplificateur suiveur 14 peut encore être prévu avec une entrée positive reliée au nœud de connexion des deux résistances Rd1 et Rd2, et une entrée négative reliée en sortie de l'amplificateur suiveur 14 pour fournir la tension de référence Ref. Si les deux résistances ont une même valeur résistive, cela conduit à fournir une tension de référence Ref égale à Vdd/2, mais les deux résistances peuvent aussi avoir des valeurs résistives différentes pour modifier la tension de référence Ref selon l'entraînement souhaité du vibreur acoustique Cb.

Selon le principe de l'invention, il est prévu dans la boucle de rétroaction avec l'ensemble 2 composé de la première inductance L1 et du vibreur acoustique Cb, d'entraîner la première bobine L1 aves des tensions positives ou impulsons de tension positives, lorsque le condensateur Cb du vibreur acoustique est en phase de charge. Par contre, la première bobine L1 reçoit une tension nulle lorsque le condensateur Cb du vibreur acoustique est en phase de décharge. Ainsi le signal de sortie Vcomp du comparateur 4 est donc dans un état haut pour la fourniture des impulsions de tension positives et dans un état bas pour la fourniture de tensions nulles.

Avec ce principe de l'invention consistant à entraîner l'oscillation avec un retour positif dans la boucle de rétroaction, cela permet d'augmenter l'énergie stockée dans le condensateur Cb du vibreur acoustique ou avertisseur sonore. Une oscillation au nœud de connexion de la première bobine L1 et du condensateur Cb est forcée proche de la fréquence de résonance. Il n'est ainsi plus nécessaire de prévoir une phase de calcul de la fréquence de résonance du vibreur acoustique, car les signaux d'entraînement sur le condensateur Cb sont capables de produire l'effet résonant pour chaque avertisseur ou vibreur acoustique durant tout le cycle de vie du dispositif électronique.

Selon une forme d'exécution décrite en référence à la figure 1, le circuit dérivateur 3 peut comprendre pour effectuer une dérivation du signal sur le condensateur Cb, un agencement comprenant un condensateur de dérivation C1, une résistance R1 et un amplificateur 13. Une première électrode du condensateur de dérivation C1 peut être reliée au nœud de connexion entre la première bobine L1 et le condensateur Cb du vibreur acoustique, et une seconde électrode est reliée à une première entrée de l'amplificateur 13. Une seconde entrée de l'amplificateur 13 est de préférence reliée à une borne de masse. Une résistance de dérivation R1 est disposée entre la première entrée de l'amplificateur 13 et la sortie de l'amplificateur 13, qui fournit un signal de sortie de la dérivée Vder. La première entrée de l'amplificateur 13 est une entrée négative, alors que la seconde entrée de l'amplificateur 13 est une entrée positive.

Le circuit dérivateur 3 peut aussi comprendre des moyens d'adaptation non représentés du niveau et de l'amplitude du signal oscillant provenant du condensateur Cb. Ce signal oscillant est de préférence une tension de forme sinusoïdale, qui peut fluctuer de -10 V à +10 V. Les signaux du circuit dérivateur doivent en principe être des signaux, dont la tension est inférieure à la tension d'alimentation Vdd du dispositif électronique 1. La tension d'alimentation Vdd peut être de l'ordre de 1 V.

Il est encore à noter que le comparateur 4 peut être un comparateur à hystérèse. Le comparateur à hystérèse permet de bien définir les deux états du signal de sortie Vcomp à fournir à la première bobine L1 sur la base de la comparaison du signal de dérivée Vder avec la tension de référence Ref, qui peut être à Vdd/2 ou à une autre tension adaptée selon l'application.

Le dispositif électronique 1 peut encore comprendre un circuit de pré-charge 9, qui est relié au nœud de connexion de la première bobine ou inductance L1 et du condensateur Cb du vibreur acoustique. Lors de la mise en fonction du dispositif électronique 1, ce circuit de pré-charge 9 permet de charger le condensateur Cb. En chargeant initialement le condensateur Cb, cela permet d'éviter, que le circuit dérivateur 3 donne un signal de dérivée Vder nul et que tous les composants de la boucle de rétroaction restent dans un état stable sans permettre la génération d'un son ou d'une musique.

Le dispositif électronique 1 peut encore comprendre un limiteur de tension 8 relié au nœud de connexion de la première bobine ou inductance L1 et du condensateur Cb du vibreur acoustique. Comme l'amplitude de la tension alternative générée sur le condensateur Cb augmente pour la génération d'un son par la membrane, le limiteur de tension 8 permet de limiter l'oscillation à une amplitude en tension définie. Ce limiteur de tension peut être conçu comme deux diodes tête bêche montées en parallèle du condensateur Cb et de tension de coupure définie.

Le dispositif électronique 1 peut comprendre encore une seconde bobine ou inductance L2 dans l'ensemble 2. Cette seconde bobine L2 est reliée à la seconde électrode du condensateur Cb du vibreur acoustique par l'intermédiaire de l'interrupteur 7. L'autre extrémité de la seconde bobine L2 est reliée à une unité logique DSP 6. Cette unité logique DSP 6 peut également être reliée à l'extrémité libre de la première bobine L1 par l'intermédiaire d'un multiplexeur 10 contrôlé par une unité de commande 5.

L'unité logique DSP 6 et les première et seconde bobines L1 et L2 sont prévues pour la génération d'une musique par exemple. A ce titre, un signal numérique audio peut être généré dans l'unité logique DSP 6. L'unité logique DSP doit comprendre encore un filtre numérique FIR disposé dans un circuit sigma-delta, qui nécessite les deux bobines L1 et L2 pour le filtrage numérique du signal de sortie afin de générer une musique ou mélodie dans le vibreur acoustique Cb.

L'unité de commande 5 du dispositif électronique 1 peut être utilisée pour enclencher les différents composants du dispositif par un signal En, ainsi que pour sélectionner la génération d'un avertissement sonore comme une alarme ou d'une musique ou mélodie. Pour la génération d'un avertissement sonore ou d'une musique, un signal de sélection Sel contrôle le multiplexeur 10, ainsi que l'interrupteur 7. Pour la génération d'un avertissement sonore dans un premier état du signal de sélection Sel, la première bobine L1 est reliée à la sortie du comparateur 4, et la seconde électrode du condensateur Cb est reliée à la masse. Pour la génération d'une mélodie dans un second état du signal de sélection Sel, la première bobine est reliée à l'unité logique DSP 6, et la seconde électrode du condensateur Cb est reliée à la seconde bobine L2 également reliée à l'unité logique DSP 6.

Comme indiqué ci-devant, le circuit de pré-charge 9 doit charger le condensateur Cb pour la mise en fonction de la boucle de rétroaction afin de générer l'avertissement sonore avec amplification automatique. Bien entendu dès que la phase d'initialisation de la boucle de rétroaction est effectuée, le circuit de pré-charge 9 peut être déconnecté. Il peut aussi être prévu de ne mettre en fonction par la commande de l'unité de commande 5, que les composants nécessaires à la génération d'un avertissement sonore ou ceux pour la génération d'une musique ou mélodie. Cependant selon l'invention et la configuration du dispositif électronique 1 présenté en référence à la figure 1, une amplification ou augmentation de l'énergie stockée sur le condensateur Cb du vibreur acoustique intervient uniquement dans le cas d'une génération d'un avertissement sonore. Dans ce cas de figure, un haut volume d'alarme peut être obtenu sans l'utilisation de circuits complémentaires DC-DC ou à pompe de charge.

Il est à noter que les première et seconde bobines L1 et L2, ainsi que le condensateur Cb du vibreur acoustique sont des composants, qui ne peuvent pas être facilement intégrés avec les autres parties du dispositif électronique 1 décrit ci-devant. A titre d'exemple non limitatif, les première et seconde inductances L1 et L2 peuvent être d'une valeur inductive de l'ordre de 100 µH, et la capacité du condensateur Cb peut être de l'ordre de 10 µF. Ceci permet de générer une fréquence de résonance d'environ 5 kHz dans la gamme audible. Dans le circuit dérivateur 3, la résistance R1 peut être de valeur résistive de l'ordre de 10 MOhms, et la capacité du condensateur de dérivation C1 peut être de l'ordre de 10 pF. Ces deux composants peuvent donc être intégrés avec les autres parties du dispositif électronique 1.

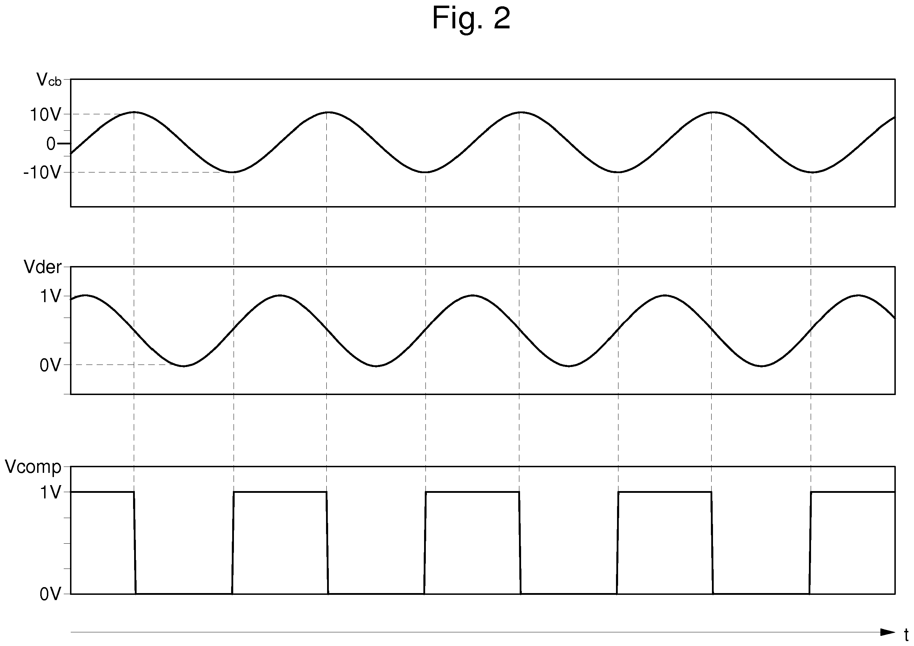

Dans le cas de la génération d'un avertissement sonore, il est représenté différents signaux dans la boucle de rétroaction à la figure 2. Sur cette figure 2, il est représenté tout d'abord le signal oscillant sur le condensateur Cb, qui est une tension sinusoïdale V_{Cb}. Ce signal oscillant sur le condensateur Cb est représenté par sa composante alternative. Sur la figure 2, il est encore représenté le signal de dérivée Vder à la sortie du circuit dérivateur, qui est également une tension sinusoïdale Vder, mais déphasée de 90° de la tenson V_{Cb}, et le signal de sortie du comparateur, qui est une tension en forme d'impulsions Vcomp pour commander la première inductance.

On remarque que selon l'invention, la tension en forme d'impulsion Vcomp est une tension positive lorsque le condensateur Cb se charge avec une tension V_{Cb}, qui augmente pendant la durée de l'impulsion de tension Vcomp. Par contre, lors de la décharge du condensateur Cb, la tension de V_{Cb} diminue avec une tension Vcomp nulle, ce qui est désiré. Ainsi une augmentation automatique de la tension sur le condensateur Cb intervient dès la mise en fonction du dispositif pour la génération d'un avertissement sonore sans besoin d'ajuster la fréquence de résonance.

Selon les signaux représentés à la figure 2, le signal de dérivée Vder est comparé à une tension de référence dans le comparateur, qui est avantageusement une tension correspondant à la moitié de la tension d'alimentation Vdd. Cela permet de fournir une impulsion positive de tension en sortie du comparateur Vcomp pendant toute la durée de charge du condensateur Cb du vibreur acoustique. Avec une faible tension positive, il est néanmoins possible d'amplifier le son généré par le vibreur acoustique grâce à la boucle de rétroaction selon l'invention.

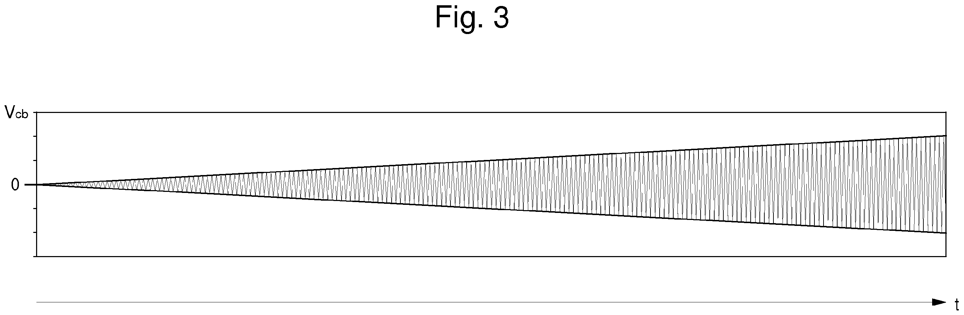

A la figure 3, il est représenté uniquement l'évolution du signal sur le condensateur Cb montrant l'augmentation de la tension sinusoïdale dans le temps. Il n'est pas montré l'influence du limiteur de tension sur cette figure 3. Dans un cas idéal, l'amplitude de l'oscillation sur le condensateur Cb peut augmenter jusqu'à quelques kVolts. Cependant dans un cas normal avec une résistance interne dans la première bobine et le vibreur acoustique, l'amplitude maximum de la tension est d'une dizaine de Volts, ce qui permet d'intégrer une bonne partie des composants du dispositif électronique.

A partir de la description qui vient d'être faite, plusieurs variantes de réalisation du dispositif électronique peuvent être conçues par l'homme du métier sans sortir du cadre de l'invention définie par les revendications. Il peut être envisagé de réaliser une boucle de rétroaction équivalente dans le dispositif électronique pour la génération d'une musique. La limite en tension du limiteur de tension peut être adaptée depuis l'unité de commande. Le dispositif électronique peut être déclenché après une période temporelle déterminée depuis sa mise en fonction.

## Revendications

1. Dispositif électronique (1) de génération d'un avertissement sonore ou d'une musique, le dispositif électronique comprenant au moins une bobine ou inductance (L1) et un vibreur acoustique, qui comprend au moins un condensateur (Cb) relié en série avec la bobine, pour la génération d'un avertissement sonore ou d'une musique lors de la mise en fonction du dispositif électronique,
le dispositif électronique (1) comprenant dans une boucle de rétroaction positive, un circuit dérivateur (3) relié à un nœud de connexion entre la bobine (L1) et le condensateur (Cb) du vibreur, pour dériver le signal provenant du condensateur (Cb), et un comparateur (4) pour comparer un signal de dérivée (Vder) fourni à la sortie du circuit dérivateur (3) avec une tension de référence (Ref), le comparateur fournissant un signal de sortie (Vcomp) à la bobine (L1) pour amplifier le signal sur le condensateur (Cb), afin de générer au moins un avertissement sonore.

2. Dispositif électronique (1) selon la revendication 1, **caractérisé en ce que** le comparateur (4) comprend une première entrée positive pour recevoir le signal de dérivée (Vder) et une seconde entrée négative pour recevoir la tension de référence (Ref), afin de fournir un signal de sortie (Vcomp) dans un état haut, c'est-à-dire avec une tension positive, à la bobine (L1), quand le condensateur (Cb) est en phase de charge, et dans un état bas, c'est-à-dire avec une tension nulle, à la bobine (L1), quand le condensateur (Cb) est en phase de décharge.

3. Dispositif électronique (1) selon la revendication 2, **caractérisé en ce que** la seconde entrée négative du comparateur (4) reçoit une tension de référence, qui est définie comme une tension égale à la moitié d'une tension d'alimentation (Vdd), afin de fournir un signal de sortie dans un état haut à la bobine (L1) pendant toute la phase de charge du condensateur (Cb).

4. Dispositif électronique (1) selon la revendication 2, **caractérisé en ce que** le comparateur (4) est un comparateur à hystérèse.

5. Dispositif électronique (1) selon la revendication 1, **caractérisé en ce que** le circuit dérivateur (3) comprend un condensateur de dérivation (C1) relié d'une part au nœud de connexion de la bobine (L1) et du condensateur (Cb) du vibreur acoustique, et d'autre part à une première entrée négative d'un amplificateur (13), une seconde entrée positive de l'amplificateur étant reliée à une tension nulle ou à une borne de masse, et une résistance (R1) reliée entre la première entrée négative et une sortie de l'amplificateur (13), qui fournit le signal de dérivée (Vder).

6. Dispositif électronique (1) selon l'une des revendications 1 et 5, **caractérisé en ce que** le dispositif électronique comprend un circuit de pré-charge (9), qui est relié au nœud de connexion de la bobine (L1) et du condensateur (Cb) de manière à charger le condensateur initialement lors de la mise en fonction du dispositif électronique.

7. Dispositif électronique (1) selon la revendication 1, **caractérisé en ce que** le dispositif électronique (1) comprend un circuit limiteur de tension (8), qui est relié au nœud de connexion de la bobine (L1) et du condensateur (Cb) pour limiter l'amplitude du signal oscillant sur le condensateur (Cb).

8. Dispositif électronique (1) selon la revendication 1, **caractérisé en ce que** le condensateur (Cb) comprend une première électrode reliée à la bobine (L1) et une seconde électrode reliée par l'intermédiaire d'un interrupteur (7) à une tension nulle ou à une borne de masse.

9. Dispositif électronique (1) selon la revendication 8, **caractérisé en ce que** le dispositif électronique (1) comprend une autre ou seconde bobine ou inductance (L2) reliée à la seconde électrode du condensateur (Cb) par l'intermédiaire de l'interrupteur (7), cet interrupteur étant commandé par une unité de commande (5) pour relier la seconde électrode du condensateur (Cb) à la borne de masse ou à la seconde bobine (L2).

10. Dispositif électronique (1) selon la revendication 9, **caractérisé en ce que** l'autre extrémité de la seconde bobine (L2) est reliée à une unité logique (6), qui est également reliée à la bobine ou première bobine (L1) par l'intermédiaire d'un multiplexeur (10) contrôlé par l'unité de commande (5), le signal de sortie (Vcomp) du comparateur (4) étant fourni à la première bobine (L1) également par l'intermédiaire du multiplexeur (10), ledit multiplexeur étant contrôlé par un signal de sélection (Sel) de l'unité de commande (5), dans un premier état du signal de sélection (Sel), la première bobine (L1) étant reliée à la sortie du comparateur (4), et la seconde électrode du condensateur (Cb) étant reliée à la borne de masse, et dans un second état du signal de sélection (Sel), la première bobine (L1) étant reliée à l'unité logique (6), et la seconde électrode du condensateur (Cb) étant reliée à la seconde bobine (L2).

## Patentansprüche

1. Elektronische Vorrichtung (1) zur Erzeugung eines akustischen Alarms oder einer Musik, wobei die elektronische Vorrichtung mindestens eine Spule oder einen Induktor (L1) und einen Warnsummer umfasst, der mindestens einen Kondensator (Cb) umfasst, der in Reihe an die Spule angeschlossen ist, zur Erzeugung eines akustischen Alarms oder einer Musik bei der Inbetriebnahme der elektronischen Vorrichtung,
wobei die elektronische Vorrichtung (1) in einer positiven Rückkopplungsschleife eine Abzweigungsschaltung (3) umfasst, die an einen Verbindungsknoten zwischen der Spule (L1) und dem Kondensator (Cb) des Summers angeschlossen ist, um das aus dem Kondensator (Cb) kommende Signal abzuzweigen, und einen Vergleicher (4) zum Vergleichen eines Abzweigungssignals (Vder), das am Ausgang der Abzweigungsschaltung (3) bereitgestellt wird, mit einer Referenzspannung (Ref), wobei der Vergleicher ein Ausgangssignal (Vcomp) für die Spule (L1) bereitstellt, um das Signal am Kondensator (Cb) zu verstärken, um mindestens einen akustischen Alarm zu erzeugen.

2. Elektronische Vorrichtung (1) nach Anspruch 1, **dadurch gekennzeichnet, dass** der Vergleicher (4) einen ersten positiven Eingang zum Empfangen des Abzweigungssignals (Vder), und einen zweiten negativen Eingang zum Empfangen der Referenzspannung (Ref) umfasst, um der Spule (L1) ein Ausgangssignal (Vcomp) in einem H-Zustand, das heißt mit einer positiven Spannung, bereitzustellen, wenn der Kondensator (Cb) in Ladephase ist, und in einem L-Zustand, das heißt mit einer Spannung gleich null, für die Spule (L1), wenn der Kondensator (Cb) in Entladephase ist.

3. Elektronische Vorrichtung (1) nach Anspruch 2, **dadurch gekennzeichnet, dass** der zweite negative Eingang des Vergleichers (4) eine Referenzspannung empfängt, die als eine Spannung gleich der Hälfte einer Versorgungsspannung (Vdd) definiert ist, um der Spule (L1) während der gesamten Ladephase des Kondensators (Cb) ein Ausgangssignal in einem H-Zustand bereitzustellen.

4. Elektronische Vorrichtung (1) nach Anspruch 2, **dadurch gekennzeichnet, dass** der Vergleicher (4) ein Hysterese-Vergleicher ist.

5. Elektronische Vorrichtung (1) nach Anspruch 1, **dadurch gekennzeichnet, dass** die Abzweigungsschaltung (3) einen Abzweigungskondensator (C1) umfasst, der einerseits an den Verbindungsknoten der Spule (L1) und des Kondensators (Cb) des Warnsummers, und andererseits an einen ersten negativen Eingang eines Verstärkers (13) angeschlossen ist, wobei ein zweiter positiver Eingang des Verstärkers an eine Null-Spannung oder eine Masseklemme und einen Widerstand (R1) angeschlossen ist, der zwischen dem ersten negativen Eingang und einem Ausgang des Verstärkers (13) angeschlossen ist, der das Abzweigungssignal (Vder) bereitstellt.

6. Elektronische Vorrichtung (1) nach einem der Ansprüche 1 bis 5, **dadurch gekennzeichnet, dass** die elektronische Vorrichtung eine Vorladeschaltung (9) umfasst, die an den Verbindungsknoten der Spule (L1) und des Kondensators (Cb) angeschlossen ist, um den Kondensator anfänglich bei der Inbetriebnahme der elektronischen Vorrichtung zu laden.

7. Elektronische Vorrichtung (1) nach Anspruch 1, **dadurch gekennzeichnet, dass** die elektronische Vorrichtung (1) eine Spannungsbegrenzungsschaltung (8) umfasst, die an den Verbindungsknoten der Spule (L1) und des Kondensators (Cb) angeschlossen ist, um die Amplitude des Schwingungssignals in dem Kondensator (Cb) zu begrenzen.

8. Elektronische Vorrichtung (1) nach Anspruch 1, **dadurch gekennzeichnet, dass** der Kondensator (Cb) eine erste Elektrode umfasst, die an die Spule (L1) angeschlossen ist, und eine zweite Elektrode, die über einen Schalter (7) an eine Null-Spannung oder an eine Masseklemme angeschlossen ist.

9. Elektronische Vorrichtung (1) nach Anspruch 8, **dadurch gekennzeichnet, dass** die elektronische Vorrichtung (1) eine weitere oder zweite Spule oder Induktor (L2) umfasst, der über den Schalter (7) an die zweite Elektrode des Kondensators (Cb) angeschlossen ist, wobei dieser Schalter durch eine Steuerungseinheit (5) gesteuert wird, um die zweite Elektrode des Kondensators (Cb) an die Masseklemme oder an die zweite Spule (L2) anzuschließen.

10. Elektronische Vorrichtung (1) nach Anspruch 9, **dadurch gekennzeichnet, dass** das andere Ende der zweiten Spule (L2) an eine Logikeinheit (6) angeschlossen ist, die über einen Multiplexer (10), der durch die Steuerungseinheit (5) kontrolliert wird, auch an die Spule oder erste Spule (L1) angeschlossen ist, wobei das Ausgangssignal (Vcomp) des Vergleichers (4) für die erste Spule (L1) auch über den Multiplexer (10) bereitgestellt wird, wobei der Multiplexer durch ein Auswahlsignal (Sel) der Steuerungseinheit (5) kontrolliert wird, wobei in einem ersten Zustand des Auswahlsignals (Sel) die erste Spule (L1) an den Ausgang des Vergleichers (4) angeschlossen ist, und die zweite Elektrode des Kondensators (Cb) an die Masseklemme angeschlossen ist, und in einem zweiten Zustand des Auswahlsignals (Sel) die erste Spule (L1) an die Logikeinheit (6) angeschlossen ist, und die zweite Elektrode des Kondensators (Cb) an die zweite Spule (L2) angeschlossen ist.

## Claims

1. Electronic device (1) for generation of an audible alarm or music, the electronic device including at least one coil or inductor (L1) and a buzzer, which includes at least one capacitor (Cb) connected in series with the coil, for generation of an audible alarm or music when the electronic device is actuated,
the electronic device (1) including in a positive feedback loop, a derivative circuit (3) connected to a connection node between the coil (L1) and the capacitor (Cb) of the buzzer, to produce a derivative of the signal from the capacitor (Cb), and a comparator (4) for comparing a derivative signal (Vder) at the output of the derivative circuit (3) with a reference voltage (Ref), the comparator supplying an output signal (Vcomp) to the coil (L1) to amplify the signal across the capacitor (Cb), in order to generate at least one audible alarm.

2. Electronic device (1) according to claim 1, **characterized in that** the comparator (4) includes a first positive input for receiving the derivative signal (Vder) and a second negative input for receiving the reference voltage (Ref), in order to supply an output signal (Vcomp) in a high state, i.e. with a positive voltage, to the coil (L1), when the capacitor (Cb) is in a charge phase, and in a low state, i.e. with a zero voltage, to the coil (L1), when the capacitor (Cb) is in a discharge phase.

3. Electronic device (1) according to claim 2, **characterized in that** the second negative input of the comparator (4) receives a reference voltage, which is defined as a voltage equal to half the supply voltage (Vdd), in order to supply an output signal in a high state to the coil (L1) throughout the entire charge phase of the capacitor (Cb).

4. Electronic device (1) according to claim 2, **characterized in that** the comparator (4) is a hysteresis comparator.

5. Electronic device (1) according to claim 1, **characterized in that** the derivative circuit (3) includes a derivative capacitor (C1) connected, on the one hand, to the connection node between the coil (L1) and the capacitor (Cb) of the buzzer, and on the other hand, to a first negative input of an amplifier (13), a second positive input of the amplifier being connected to a zero voltage or to an earth terminal, and a resistor (R1) connected between the first negative input and an output of the amplifier (13), which supplies the derivative signal (Vder).

6. Electronic device (1) according to any of claims 1 and 5, **characterized in that** the electronic device includes a pre-charge circuit (9), which is connected to the connection node between the coil (L1) and the capacitor (Cb) in order to pre-charge the capacitor when the electronic device is actuated.

7. Electronic device (1) according to claim 1, **characterized in that** the electronic device (1) includes a voltage limiter circuit (8), which is connected to the connection node between the coil (L1) and the capacitor (Cb) to limit the amplitude of the oscillating signal across the capacitor (Cb).

8. Electronic device (1) according to claim 1, **characterized in that** the capacitor (Cb) includes a first electrode connected to the coil (L1) and a second electrode connected by means of a switch (7) to a zero voltage or to an earth terminal.

9. Electronic device (1) according to claim 8, **characterized in that** the electronic device (1) includes another or a second coil or inductor (L2) connected to the second electrode of the capacitor (Cb) by means of the switch (7), this switch being controlled by a control unit (5) to connect the second electrode of the capacitor (Cb) to the earth terminal or to the second coil (L2).

10. Electronic device (1) according to claim 9, **characterized in that** the other end of the second coil (L2) is connected to a logic unit (6) which is also connected to the coil or first coil (L1) by means of a multiplexer (10) controlled by the control unit (5), the output signal (Vcomp) of the comparator (4) being supplied to the first coil (L1) also by means of the multiplexer (10), said multiplexer being controlled by a selection signal (Sel) of the control unit (5), in a first state of the selection signal (Sel), the first coil (L1) being connected to the output of the comparator (4), and the second electrode of the capacitor (Cb) being connected to the earth terminal, and in a second state of the selection signal (Sel), the first coil (L1) being connected to the logic unit (6), and the second electrode of the capacitor (Cb) being connected to the second coil (L2
